(19) Europäisches Patentamt

European Patent Office

Office européen des brevets

(11) **EP 0 919 083 B1**

(12) **EUROPEAN PATENT SPECIFICATION**

(45) Date of publication and mention
of the grant of the patent:
**14.05.2003 Bulletin 2003/20**

(21) Application number: **98903236.2**

(22) Date of filing: **27.02.1998**

(51) Int Cl.7: **H03H 17/06**

(86) International application number:
**PCT/IB98/00251**

(87) International publication number:
**WO 98/043349 (01.10.1998 Gazette 1998/39)**

(54) **RECEIVER WITH A SIMPLIFIED SAMPLE RATE CONVERTER**

EMPFÄNGER MIT EINEM VEREINFACHTEN ABTASTRATENUMSETZER

RECEPTEUR AVEC CONVERTISSEUR DE FREQUENCE D'ECHANTILLONNAGE SIMPLIFIE

(84) Designated Contracting States:
**DE FR GB**

(30) Priority: **21.03.1997 EP 97200846**

(43) Date of publication of application:
**02.06.1999 Bulletin 1999/22**

(73) Proprietor: **Koninklijke Philips Electronics N.V.**
**5621 BA Eindhoven (NL)**

(72) Inventors:
• **DILLING, Edwin, Robert**
**NL-5656 AA Eindhoven (NL)**
• **NILLESEN, Antonius, Hendrikus, Hubertus,**
**Jozef**
**NL-5656 AA Eindhoven (NL)**

(74) Representative:
**Deguelle, Wilhelmus Hendrikus Gerardus et al**
**INTERNATIONAAL OCTROOIBUREAU B.V.,**
**Prof. Holstlaan 6**
**5656 AA Eindhoven (NL)**

(56) References cited:
**US-A- 4 700 345** **US-A- 5 058 107**

**Description**

The present invention is related to a receiver comprising a first filter for deriving a first signal having a first sample frequency from an input signal, and a second filter for deriving a second signal having a second sample rate from the first signal.

The invention is also related to a sample rate converter for converting a first signal with a first sample rate to a second signal with a second sample rate.

A receiver according to the preamble is known from US Patent No. 5,058,107.

Such receivers can be used for receiving (digital) broadcast signals e.g. DAB and DVB signals. In such a receiver the RF signal at the input is converted into a digital signal after its has been down converted to a signal with a frequency substantially lower than the frequency of the RF signal. The conversion of the analog signal to a digital signal is performed by an analog to digital converter, which samples the analog signal at a first sample rate and converts it into a digital signal with said first sample rate. In general the first sample frequency is fixed, and its value is chosen to meet the sampling theorem.

In receivers for digital signals it is convenient to process the digital signal with a second sample rate which is a multiple of the symbol rate of the received signal. This processing can comprise filtering with a so-called half Nyquist filter. In order to be able to do so, the signal with the first sample rate has to be converted to a signal with a second sample rate. In order to prevent so-called aliasing, the first filter is arranged for filtering the first signal in such a way that the sampling theorem for the second signal is still met. If the second sampling rate is substantially lower than the first sampling rate, the first filter has a very narrow transition band in which the attenuation of the first filter increases from the low value in the pass band to the high value in the stop band. Such narrow transition band requires a quite complex filter.

The object of the present invention is to provide a receiver according to the preamble in which the complexity of the first filter has been substantially reduced.

Therefor the receiver according to the invention is characterized in that the upper limit of the transition band of the first filter is larger than half the second sample rate and smaller than a difference between the second sample rate and said cut off frequency of the second filter.

The present invention is based on the recognition that the first filter does not have to suppress signals with a frequency between the cut off frequency of the second filter and the difference between the second sample rate and said cut off frequency, because in said frequency range no signals are passed by the second filter. Consequently it is possible that the upper limit of the transition band is larger than half the second sampling rate, without any aliasing being introduced.

An embodiment of the invention is characterized in that the second sample rate comprises a plurality of possible sample rates, and in that the upper limit of the transition band of the first filter is larger than half of at least one of said plurality of sample rates, and smaller than a difference between the smallest of the possible values of the second sample rate and said cut off frequency of the second filter for the smallest of the possible values of the second sample rate.

In several receivers the symbol rate can have different values. Examples are voice band modems for the PSTN, or receivers used in DVB. In the latter the symbol rate may vary between 1 Mbaud and 45 Mbaud. Consequently, the second sample rate has to be adapted accordingly. By choosing the transition band according to the above mentioned inventive concept, a single filter is obtained that can deal with all symbol rates.

A further embodiment of the invention is characterized in that the second sample rate comprises an additional plurality of sample rates with values higher than the values of the plurality of sample frequencies, in that the transfer function of the first filter has a value of H(f) if the sample rate has one of the plurality of sample rates and in that the transfer function of the second filter is switched to a value of H(0) -½{H( f-f$_{SAMPLE/2}$)+H(f+f$_{SAMPLE/2}$) if the actual sample frequency is equal to one of the additional plurality of sample rates.

The larger the number of possible values of the second sample rate, the steeper the first filter has to be, resulting in an increased complexity of the filter. Hence, it may be advantageous to use different filter coefficients for the additional plurality of sample rates. A convenient way to obtain this different filter coefficients is to invert some of the filter coefficients of the first filter, and subtracting the middle coefficient of the filter from 1.

A further embodiment of the invention is characterized in that the first filter comprises time shared filtering means for performing a plurality of successive filtering and sample rate reduction operations, each of said successive filter and sample rate reduction operations being performed on the result of the previous filter and sample rate reduction operation.

A convenient way to realize the first filter is a cascade of filter sections and decimators. Because the required computational effort decreases for each stage, it becomes possible to use a filter in time multiplex to perform all the filtering. If e.g. decimators having a decimation factor of 2 are used, the required computational effort is for each stage a factor 2 lower than that of the previous stage. If a filter having a computation speed twice the computation speed required for the first filter stage, any desired number of filter stages can be realized.

The invention will now be explained with reference to the drawing figures. Herein shows:

Fig. 1, a receiver in which the invention can be used;
Fig. 2, an embodiment of the sample rate converter 14 according to Fig. 1;
Fig. 3, graphs of the transfer functions of the first and second filter according to the present invention;
Fig. 4, the transfer functions of a switched first filter according to an embodiment of the invention;
Fig. 5, an alternative embodiment of the first filter according to the invention.

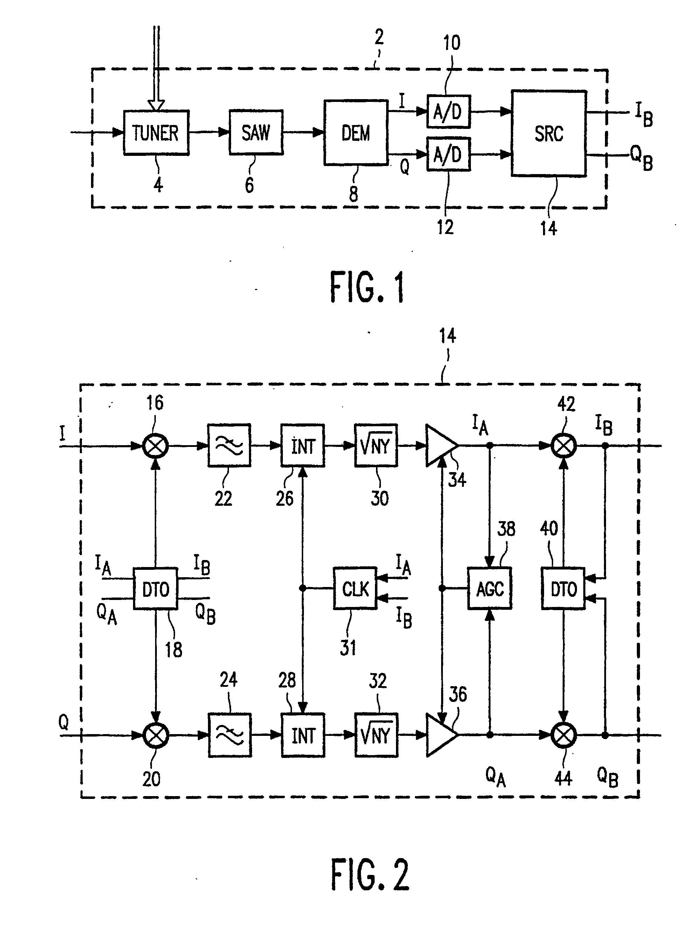

In the receiver 2 according to Fig. 1, an input signal is applied to a first input of a tuner 4. A control signal, carrying a signal representing the selected channel, is applied to a second input of the tuner 4. An IF output of the tuner 4 is connected to an input of a SAW (Surface Acoustic Wave) filter 6. An output of the SAW filter 6 is connected to an input of a demodulator 8.

A first output of the demodulator 8, carrying an in-phase signal I, is connected to an input of an analog to digital converter 10. A second output of the demodulator, carrying a quadrature signal Q, is connected to an input of an analog to digital converter 12. The output of the analog to digital converter 10 is connected to a first input of a sample rate converter 14. The output of the analog to digital converter 12 is connected to a second input of the sample rate converter 14. The sample rate converter presents its output as an in-phase signal $I_B$ and a quadrature signal $Q_B$.

The tuner 4 converts the selected input signal into an IF signal with a nominal frequency of 480 MHz. In case of a receiver intended for DBS reception, the IF frequency can differ by 5 MHz from the nominal frequency due to drift of the local oscillator used in the LNC in the outdoor unit.

The SAW filter 6 provides the adjacent channel selectivity. Its bandwidth is chosen 10 MHz wider than the maximum bandwidth of the signal to be received. The additional 10 MHz is chosen in order to prevent that desired signal falls outside the pass band of the SAW filter due to tolerances and drift of the LNC.

In the demodulator 8 the input signal is mixed with a quadrature oscillator signal having a fixed frequency of 480 MHz. At the output of the demodulator 8, demodulated signals I and Q are available. These quadrature signals are sampled with the first sample rate and converted into digital signals by the analog to digital converters 10 and 12. In the case of a receiver for DVB a suitable choice for said first sample rate is 64 MHz.

The sample rate converter 14 converts the quadrature signals sampled by the first sample rate into quadrature signals sampled with a sample rate twice the actual symbol rate. The symbol rate can vary from 12 to 24 MHz. The sample rate converter 14 is also arranged for eliminating frequency and phase offsets of the signal at its input.

In the sample rate converter 14 according to Fig. 2, the in-phase signal I is applied to a first input of a mixer 16, and the quadrature signal Q is applied to a first input of a mixer 20. A first output of a digital tunable oscillator (DTO) 18 is connected to a second input of the mixer 16 and a second output of a digital tunable oscillator 18 is connected to a second input of the mixer 20. An output of the mixer 16 is connected to an input of the first (in-phase) filter, being here a low pass filter 22. An output of the mixer 20 is connected to an input of the first (quadrature) filter, being here a low pass filter 24. An output of the low pass filter 32 is connected to an input of a decimator 26, and an output of the low pass filter 24 is connected to an input of a decimator 28. The output of the decimator 26 is connected to an input of a square root Nyquist filter 30 and the output of the decimator 28 is connected to an input of a square root Nyquist filter 32. The combination of the decimator 26, the square root Nyquist filter 30, the decimator 28 and the square root Nyquist filter 32 constitute the second (in-phase and quadrature) filter. The decimators 26 and 28 are controlled by a clock signal being generated by a clock signal recovery circuit 31. The frequency of said clock signal corresponds to twice the symbol rate $f_{SYMBOL}$.

The output of the filter 30 is connected to an input of an AGC amplifier 34, and the output of the filter 32 is connected to an input of an AGC amplifier 36. An output of the AGC amplifier 34, carrying output signal $I_A$, is connected to a first input of a mixer 42 and to a first input of a AGC controller 38. An output of the AGC amplifier 36, carrying output signal $Q_B$, is connected to a first input of a mixer 44 and to a second input of the AGC controller 38. An output of the AGC controller 38 is connected to a control input of the AGC amplifiers 34 and 36.

A first output of a digital oscillator 40 is connected to a second input of the mixer 42, and a second output of the digital oscillator 40 is connected to a second input of the mixer 44. The output of the mixer 42 is connected to a first input of the digital oscillator 40, and an output of the mixer 44 is connected to a second input of the digital oscillator 40.

At the outputs of the mixers 42 are also the output signals $I_B$ and $Q_B$ are available. The purpose of the combination of the mixers 16 and 20 and the digital tunable oscillator 18 is to provide a signal for the first (in-phase and quadrature ) filters 22 and 24 being free from frequency offsets. This is done by measuring the frequency of the signals $I_A$ and $Q_A$, and adjusting the oscillator 18 if the frequency of said signals differs from 0. The output signals of the mixers 16 and 20 are filtered by the first filters 22 and 24 in order to prevent aliasing due to the decrease of the sample rate in the decimators 26 and 28.

The decimators 26 and 28 convert their input signals with the first sample rate (e.g. 64 MHz) into an output signal with a second sample rate being equal to twice the actual symbol rate of the signal received. This second sampling rate can e.g. vary from 24 to 48 MHz. The decimators 26 and 28 are known to those skilled in the art and are e.g. described in the article Interpolation in Digital Modems - Part I: Fundamentals, by F.M. Gardner in IEEE transactions on communications, Vol. 41, No. 3, March 1993, pp. 501-507 and in the article Interpolation in Digital Modems - Part II: Implementation and performance, by L. Erup, F.M. Gardner and R.A. Harris in IEEE transactions on communications, Vol. 41, No. 6, June 1993, pp. 998-1008. An alternative embodiment of the decimators 26 and 28 is described in US patent No. 5,349,548.

The output signals of the decimators 26 and 28 are filtered by means of the filters 30 and 32 which have a square root Nyquist transfer function. For this transfer function can be written:

$$|H(f)|^2 = \begin{cases} 1 & ; f \leq \dfrac{f_{SYMBOL}(1-\alpha)}{2} \\ \dfrac{1}{2}\{1+\cos(\ \pi\dfrac{2f - f_{SYMBOL}(1-\alpha)}{2\alpha f_{SYMBOL}})\} & ; \dfrac{f_{SYMBOL}(1-\alpha)}{2} < f \leq \dfrac{f_{SYMBOL}(1+\alpha)}{2} \\ 0 & ; f > f \leq \dfrac{f_{SYMBOL}(1+\alpha)}{2} \end{cases} \qquad (1)$$

In **(1)** $|H(f)|^2$ is the square of the modulus of the transfer function of the filters 30 and 32, $f_{SYMBOL}$ is the actual symbol frequency, and $\alpha$ is the so-called roll-off factor.

The amplifiers 34 and 36 together with the AGC controller 38 provide an output signal having a constant amplitude. The mixers 42 and 44 are arranged for eliminating phase errors from the output signals of the amplifiers 34 and 36. Therefor the output signals of the amplifiers are mixed with a signal from the controlled oscillator 40 which uses the output signals $I_B$ and $Q_B$ of the mixers 42 and 44 for comparison with a reference value in order to determine the phase error. The signals $I_B$ and $Q_B$ constitute the output signals of the sampling rate converter 14.

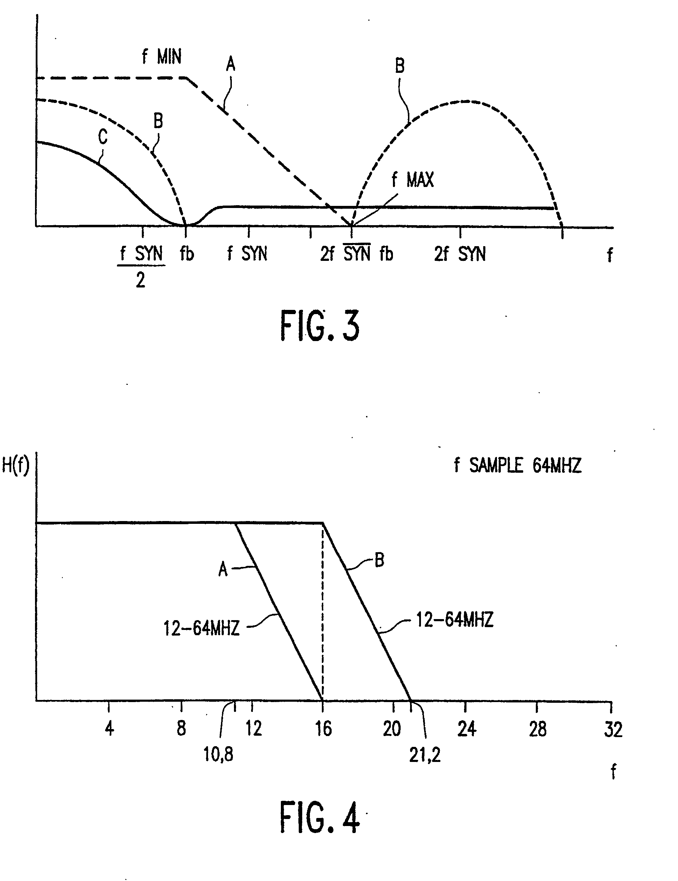

In Fig. 3 the spectrum of the input signal of the sample rate converter 14 is indicated with letter C. It is assumed that the spectrum of the input signal is shaped in the transmitter according to a square root Nyquist filter with the same value of $\alpha$ as is used in the receiver. This spectrum has non-zero components for $f < f_B$, with $f_B = (1+\alpha)\ f_{SYMBOL}/2$. Due to non ideal filtering, and the introduction of noise and interfering signals on the transmission medium the input signal of the sample rate converter 14 can also have substantial values for frequencies larger than $f_B$. From 0 Fig. 3 it can be seen that all signals having frequencies b between $f_B$ and $2f_{SYMBOL}-f_B$ are suppressed by the square root Nyquist filters 30 and 32 as can be seen from graph B in Fig. 3. Consequently the transition band of the anti aliasing filters 22 and 24 can be from $f_B$ and $2f_{SYMBOL}-f_B$, as is shown in graph A in Fig. 3. Using the relation between $f_B$ and $f_{SYMBOL}$ presented above, for the range of the transition band is found:

$$f_{MIN} = (1+\alpha)\frac{f_{SYMBOL}}{2}$$

$$\qquad (2)$$

$$f_{MAX} = (3-\alpha)\frac{f_{SYMBOL}}{2}$$

The above mentioned value for $f_{MIN}$ is determined under the assumption that the first filter performs no filtering for frequencies below $f_B$. If some filtering below $f_B$ is tolerated, the value of $f_{MIN}$ may be lower.

In the table below the relation between the symbol frequency and the frequencies $f_{MIN}$ 20 and $f_{MAX}$ is given for $\alpha=0.35$ .

| $F_{SYMBOL}$ (MHz) | $f_{MIN}$ (MHz) | $f_{MAX}$ (MHz) |
|---|---|---|
| 12 | 8.1 | 15.9 |

(continued)

| F$_{SYMBOL}$ (MHz) | f$_{MIN}$ (MHz) | f$_{MAX}$ (MHz) |
|---|---|---|
| 14 | 9.5 | 18.6 |
| 16 | 10.8 | 21.2 |
| 18 | 12.2 | 23.9 |
| 20 | 13.5 | 26.5 |
| 22 | 14.9 | 29.2 |
| 24 | 16.2 | 31.8 |

The requirements according to the above mentioned table cannot be met by a single filter with a fixed values of f$_{MIN}$ and f$_{MAX}$, because the largest value of f$_{MIN}$ is larger than the smallest value of f$_{MAX}$. A solution to this problem is to use a filter with two sets of coefficients which are switched in dependence on the symbol frequency. A possible solution is to use a first set of coefficients for symbol frequencies from 12-16 MHz, having a transition band from 10.8-15.9 MHz, and a second set of coefficients for symbol frequencies from 16 to 24 MHz, having a transition band from 16.2-21.2 MHz.

According to a further aspect of the present invention these two sets of coefficients can be realized in a very easy way if the transfer functions corresponding to both sets of filters are made symmetrical around 16 MHz. Fig. 3 shows this symmetry in graphs A and B.

The relation between the transfer functions H'(f) and H(f) corresponding to the two sets of coefficients is given by:

$$H'(f)=1-\frac{1}{2}\{H(f-f_{SYMBOL}/2)+H(f+f_{SYMBOL}/2)\} \tag{3}$$

The coefficients of the filter H'(f) can easily be found from the coefficients of the filter H(f). The middle coefficient of the filter H'(f) can be found by subtracting the middle coefficient of the filter H(f) from 1. The remaining coefficients of the filter H'(f) can be found by alternatively inverting the sign of the coefficients of the filter H(f) starting from the middle coefficient. If the coefficients of the filter H(f) are 0.1, 0.2, 0.4, 0.2, 0.6, 0.2, 0.4, 0.2, 0.1, the coefficients of the filter H'(f) are equal to -0.1, 0.2, -0.4, 0.2, 0.4, 0.2, -0.4, 0.2, -0.1.

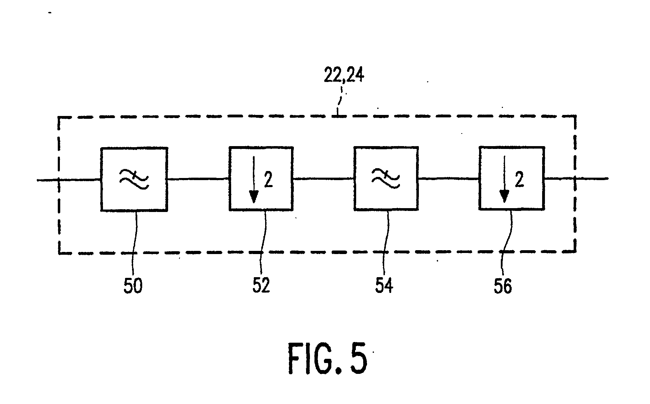

In the first filters 22, 24 according to Fig. 5, the input is connected to an input of a low pass filter 50. The output of the low pass filter 50 is connected to an input of a decimator 52. The output of the decimator 50 is connected to an input of a low pass filter 54. The output of the low pass filter 54 is connected to an input of a decimator 56.

In order to be able to realize an anti-aliasing filter over a frequency range of a number octaves, a plurality of filters with decimators can be used as is shown in Fig. 5. Each of the filters realizes an anti-aliasing operation sufficient to prevent aliasing after the corresponding decimation operation has taken place. According to a further aspect of the invention, the plurality of anti-aliasing filters can be realized on one single filter by using time sharing.

If decimation by a factor of two is being used, each following filter requires only half the time slots required for the previous filter. If three filters are present which are numbered 1,2,3, the time slot allocation can be done according to the table below.

| #filter | 1 | 2 | 1 | 3 | 1 | 2 | 1 | | 1 | 2 | 1 | 3 | 1 | 2 | 1 |
|---|---|---|---|---|---|---|---|---|---|---|---|---|---|---|---|
| t (T$_{SYMBOL}$) | 1 | 2 | 3 | 4 | 5 | 6 | 7 | 8 | 9 | 10 | 11 | 12 | 13 | 14 | 15 |

From the table it is clear that still some time slots are unused. In these unused time slot a fourth filter running at half the sample rate of the third filter could be realized, leaving still some unused time slot in which a fifth filter could be implemented. In this way an arbitrary numbers of decimating filters can be realized using a single filter in time sharing.

**Claims**

1.  Receiver comprising a first filter for deriving a first signal having a first sample frequency from an input signal, and a second filter for deriving a second signal having a second sample rate from the first signal, **characterized in that** the upper limit of the transition band of the first filter is larger than half the second sample rate and smaller than a difference between the second sample rate and said cut off frequency of the second filter.

2. Receiver according to claim 1, **characterized in that** the second sample rate comprises a plurality of possible sample rates, and **in that** the upper limit of the transition band of the first filter is larger than half of at least one of said plurality of sample rates, and smaller than a difference between the smallest of the possible values of the second sample rate and said cut off frequency of the second filter for the smallest of the possible values of the second sample rate.

3. Receiver according to claim 2, **characterized in that** the second sample rate comprises an additional plurality of sample rates with values higher than the values of the plurality of sample frequencies, **in that** the transfer function of the first filter has a value of H(f) if the sample rate has one of the plurality of sample rates and **in that** the transfer function of the second filter is switched to a value of $H(0) -\frac{1}{2}\{ H( f-f_{SAMPLE/2})+H(f+f_{SAMPLE/2})$ if the actual sample frequency is equal to one of the additional plurality of sample rates.

4. Receiver according to one of the previous claims, **characterized in that** the first filter comprises time shared filtering means for performing a plurality of successive filtering and sample rate reduction operations, each of said successive filter and sample rate reduction operations being performed on the result of the previous filter and sample rate reduction operation.

5. Sample rate converter comprising a first filter for deriving a first signal having a first sample frequency from an input signal, and a second filter for deriving an second signal having a second sample rate from the first signal, **characterized in that** the upper limit of the transition band of the first filter is larger than half the second sample rate and smaller than a difference between the second sample rate and said cut off frequency of the second filter.

6. Sample rate converter according to claim 5, **characterized in that** the second sample rate comprises a plurality of possible sample rates, and **in that** the upper limit of the transition band of the first filter is larger than half of at least one of said plurality of sample rates, and smaller than a difference between the smallest of the possible values of the second sample rate and said cut off frequency of the second filter for the smallest of the possible values of the second sample rate.

7. Sample rate converter according to claim 6, **characterized in that** the second sample rate comprises an additional plurality of sample rates with values higher than the values of the plurality of sample frequencies, **in that** the transfer function of the first filter has a value of H(f) if the sample rate has one of the plurality of sample rates and **in that** the transfer function of the second filter is switched to a value of $H(0) -\frac{1}{2}\{ H( f-f_{SAMPLE/2})+H(f+f_{SAMPLE/2})\}$ if the actual sample frequency is equal to one of the additional plurality of sample rates.

8. Sample rate converter according to claims 5, 6 or 7, **characterized in that** the first filter comprises time shared filtering means for performing a plurality of successive filtering and sample rate reduction operations, each of said successive filter and sample rate reduction operations being performed on the result of the previous filter and sample rate reduction operation.

**Patentansprüche**

1. Empfänger mit einem ersten Filter zum Ableiten eines ersten Signals mit einer ersten Abtastfrequenz von einem Eingangssignal, und mit einem zweiten Filter zum Ableiten eines zweiten Signals mit einer zweiten Abtastrate von dem ersten Signal, **dadurch gekennzeichnet, dass** die obere Grenze des Übergangsbereiches des ersten Filters größer ist als die Hälfte der zweiten Abtastrate und kleiner als die Differenz zwischen der zweiten Abtastrate und der genannten Grenzfrequenz des zweiten Filters.

2. Empfänger nach Anspruch 1, **dadurch gekennzeichnet, dass** die zweite Abtastrate eine Vielzahl von möglichen Abtastraten umfasst, und dass die obere Grenze des Übergangsbereichs des ersten Filters größer ist als die Hälfte von mindestens einer aus der Vielzahl der Abtastraten, und kleiner als die Differenz zwischen dem kleinsten der möglichen Werte der zweiten Abtastrate und der genannten Grenzfrequenz des zweiten Filters für den kleinsten der möglichen Werte der zweiten Abtastrate.

3. Empfänger nach Anspruch 2, **dadurch gekennzeichnet, dass** die zweite Abtastrate eine weitere Vielzahl von Abtastraten mit Werten umfasst, die höher sind als die Werte der Vielzahl von Abtastfrequenzen; dass die Transferfunktion des ersten Filters einen Wert von H(f) hat, wenn die Abtastrate eine aus der Vielzahl von Abtastraten aufweist, und dass die Transferfunktion des zweiten Filters auf einen Wert von H (f - $f_{ABTAST/2}$) + H(f + $f_{ABTAST/2}$)} geschaltet wird, wenn die tatsächliche Abtastfrequenz gleich einer aus der weiteren Vielzahl von Abtastraten ist.

4. Empfänger nach einem der vorhergehenden Ansprüche, **dadurch gekennzeichnet, dass** der erste Filter ein Time-Sharing-Filtermittel zum Durchführen einer Vielzahl von aufeinanderfolgenden Operationen zur Filterung und Abtastratenreduzierungen enthält, wobei jede der genannten aufeinander folgenden Operationen zur Filterung und Abtastratenreduzierung basierend auf dem Ergebnis der vorhergehenden Operation zur Filterung und Abtastratenreduzierung durchgeführt wird.

5. Abtastratenumsetzer mit einem ersten Filter zum Ableiten eines ersten Signals mit einer ersten Abtastfrequenz von einem Eingangssignal, und mit einem zweiten Filter zum Ableiten eines zweiten Signals mit einer zweiten Abtastrate von dem ersten Signal, **dadurch gekennzeichnet, dass** die obere Grenze des Übergangsbereiches des ersten Filters größer ist als die Hälfte der zweiten Abtastrate und kleiner als die Differenz zwischen der zweiten Abtastrate und der genannten Grenzfrequenz des zweiten Filters.

6. Abtastratenumsetzer nach Anspruch 5, **dadurch gekennzeichnet, dass** die zweite Abtastrate eine Vielzahl von möglichen Abtastraten umfasst, und dass die obere Grenze des Übergangsbereichs des ersten Filters größer ist als die Hälfte von mindestens einer aus der Vielzahl der Abtastraten, und kleiner als die Differenz zwischen dem kleinsten der möglichen Werte der zweiten Abtastrate und der genannten Grenzfrequenz des zweiten Filters für den kleinsten der möglichen Werte der zweiten Abtastrate.

7. Abtastratenumsetzer nach Anspruch 6, **dadurch gekennzeichnet, dass** die zweite Abtastrate eine weitere Vielzahl von Abtastraten mit Werten umfasst, die höher sind als die Werte der Vielzahl von Abtastfrequenzen; dass die Transferfunktion des ersten Filters einen Wert von H(f) hat, wenn die Abtastrate eine aus der Vielzahl von Abtastraten aufweist, und dass die Transferfunktion des zweiten Filters auf einen Wert von H(0) - ½ {H (f - $f_{ABTAST/2}$) + H(f+ $f_{ABTAST/2}$)} geschaltet wird, wenn die tatsächliche Abtastfrequenz gleich einer aus der weiteren Vielzahl von Abtastraten ist.

8. Abtastratenumsetzer nach den Ansprüchen 5, 6 oder 7, **dadurch gekennzeichnet, dass** der erste Filter ein Time-Sharing-Filtermittel zum Durchführen einer Vielzahl von aufeinanderfolgenden Operationen zur Filterung und Abtastratenreduzierungen enthält, wobei jede der genannten aufeinander folgenden Operationen zur Filterung und Abtastratenreduzierung basierend auf dem Ergebnis der vorhergehenden Operation zur Filterung und Abtastratenreduzierung durchgeführt wird.

## Revendications

1. Récepteur comprenant un premier filtre destiné à dériver un premier signal présentant une première fréquence d'échantillonnage à partir d'un signal d'entrée, et un second filtre destiné à dériver un second signal présentant une seconde fréquence d'échantillonnage à partir du premier signal, **caractérisé en ce que** la limite supérieure de la bande de transition du premier filtre est supérieure à la moitié de la seconde fréquence d'échantillonnage et inférieure à une différence entre la seconde fréquence d'échantillonnage et ladite fréquence de coupure du second filtre.

2. Récepteur suivant la revendication 1, **caractérisé en ce que** la seconde fréquence d'échantillonnage comprend une pluralité de fréquences d'échantillonnage possibles, et **en ce que** la limite supérieure de la bande de transition du premier filtre est supérieure à la moitié d'au moins une fréquence de ladite pluralité de fréquences d'échantillonnage, et inférieure à une différence entre la plus basse des valeurs possibles de la seconde fréquence d'échantillonnage et ladite fréquence de coupure du second filtre, pour la plus basse des valeurs possibles de la seconde fréquence d'échantillonnage.

3. Récepteur suivant la revendication 2, **caractérisé en ce que** la seconde fréquence d'échantillonnage comprend une pluralité supplémentaire de fréquences d'échantillonnage présentant des valeurs supérieures aux valeurs de la pluralité de fréquences d'échantillonnage, **en ce que** la fonction de transfert du premier filtre a une valeur de H (f) si la fréquence d'échantillonnage présente l'une de la pluralité de fréquences d'échantillonnage, et **en ce que** la fonction de transfert du second filtre est commutée sur une valeur de H(0)-1/2{H(f-$f_{SAMPLE/2}$)+H(f+$f_{SAMPLE/2}$) si la fréquence d'échantillonnage réelle est égale à l'une des fréquences de la pluralité supplémentaire de fréquences d'échantillonnage.

4. Récepteur suivant l'une quelconque des revendications précédentes, **caractérisé en ce que** le premier filtre comprend des moyens de filtrage à partage de temps destinés à exécuter plusieurs opérations successives de filtrage et de réduction de fréquence d'échantillonnage, chacune desdites opérations successives de filtrage et de réduction de la fréquence d'échantillonnage étant exécutée sur le résultat de l'opération précédente de filtrage et de réduction de la fréquence d'échantillonnage.

5. Convertisseur de fréquence d'échantillonnage comprenant un premier filtre destiné à dériver un premier signal présentant une première fréquence d'échantillonnage à partir d'un signal d'entrée, et un second filtre destiné à dériver un second signal présentant une seconde fréquence d'échantillonnage à partir du premier signal, **caractérisé en ce que** la limite supérieure de la bande de transition du premier filtre est supérieure à la moitié de la seconde fréquence d'échantillonnage et inférieure à une différence entre la seconde fréquence d'échantillonnage et ladite fréquence de coupure du second filtre.

6. Convertisseur de fréquence d'échantillonnage suivant la revendication 5, **caractérisé en ce que** la seconde fréquence d'échantillonnage comprend une pluralité de fréquences d'échantillonnage possibles, et **en ce que** la limite supérieure de la bande de transition du premier filtre est supérieure à la moitié d'au moins une fréquence d'échantillonnage de ladite pluralité de fréquences d'échantillonnage, et inférieure à une différence entre la plus basse des valeurs possibles de la seconde fréquence d'échantillonnage et ladite fréquence de coupure du second filtre, pour la plus basse des valeurs possibles de la seconde fréquence d'échantillonnage.

7. Convertisseur de fréquence d'échantillonnage suivant la revendication 6, **caractérisé en ce que** la seconde fréquence d'échantillonnage comprend une pluralité supplémentaire de fréquences d'échantillonnage présentant des valeurs supérieures aux valeurs de la pluralité de fréquences d'échantillonnage, **en ce que** la fonction de transfert du premier filtre présente une valeur de H(f) si la fréquence d'échantillonnage présente l'une des fréquences de la pluralité de fréquences d'échantillonnage, et **en ce que** la fonction de transfert du second filtre est commutée sur une valeur de $H(0)-1/2\{H(f-f_{SAMPLE/2})+H(f+f_{SAMPLE/2})$ si la fréquence d'échantillonnage réelle est égale à l'une des fréquences d'échantillonnage de la pluralité supplémentaire de fréquences d'échantillonnage.

8. Convertisseur de fréquence d'échantillonnage suivant la revendication 5, 6 ou 7, **caractérisé en ce que** le premier filtre comprend des moyens de filtrage à partage de temps destinés à exécuter une pluralité d'opérations successives de filtrage et de réduction de la fréquence d'échantillonnage, chacune desdites opérations successives de filtrage et de réduction de la fréquence d'échantillonnage étant exécutée sur le résultat de l'opération précédente de filtrage et de réduction de la fréquence d'échantillonnage.

FIG. 1

FIG. 2

FIG. 3

FIG. 4

22,24

50      52      54      56

# FIG. 5